# EUROPEAN PATENT APPLICATION

(11) **EP 4 718 209 A1**
(43) Date of publication of application: **01.04.2026**
(21) Application number: 25200552.5
(22) Date of filing: 05.09.2025
(51) Int. Cl.: G06F 1/20, H05K 5/02

(54) **ELECTRONIC DEVICE**

(30) Priority: 27.09.2024 TW 113136908
(71) Applicant: WNC Corporation, Hsinchu 308 (TW)
(72) Inventor: CHANG, Feng-Ming, 308 Hsinchu (TW); HUANG, Bau-Yi, 308 Hsinchu (TW)
(74) Representative: Ter Meer Steinmeister & Partner

(57) **Abstract**

An electronic device is provided. The electronic device includes a device housing and an electronic component. The device housing includes a plurality of first ribs and a plurality of second ribs. The first ribs are arranged on a first plane. The second ribs are arranged on a second plane, which is parallel to the first plane. At least one first heat dissipation opening is formed between the first ribs, and at least one second heat dissipation opening is formed between the second ribs. On a projection plane parallel to the first plane, at least a portion of the second ribs are staggered with at least a portion of the first ribs. The electronic component is located inside the device housing, and the first and second ribs provide visual obstruction for the electronic component.

## Description

This application claims priority to Taiwan Patent Application No. 113136908, filed on September 27, 2024.

Some references, which may include patents, patent applications and various publications, may be cited and discussed in the description of this disclosure. The citation and/or discussion of such references is provided merely to clarify the description of the present disclosure and is not an admission that any such reference is "prior art" to the disclosure described herein. All references cited and discussed in this specification are incorporated herein by reference in their entireties and to the same extent as if each reference was individually incorporated by reference.

### BACKGROUND OF THE INVENTION

### Field of the Invention

This disclosure relates to an electronic device, particularly to an electronic device having a device housing.

### Description of the Related Art

A conventional electronic device (e.g., a router) includes a device housing and electronic components, with the electronic components being disposed within the device housing. To provide heat dissipation functionality, heat dissipation vents are formed on the device housing to allow airflow through the heat dissipation vents, thereby enhancing the heat dissipation effect. For good heat dissipation, the airflow must smoothly pass through the heat dissipation vents. However, users can directly see the electronic components inside the device housing through the heat dissipation vents, which is visually unappealing. Therefore, achieving both heat dissipation efficiency and visual aesthetics has become a design challenge.

### BRIEF SUMMARY OF THE INVENTION

Embodiments of this disclosure are provided to solve the problems of prior art by offering an electronic device comprising a device housing and an electronic component. The device housing includes a plurality of first ribs and a plurality of second ribs. The first ribs are arranged on a first plane. The second ribs are arranged on a second plane, the second plane being parallel to the first plane, wherein at least one first heat dissipation opening is formed between the first ribs, at least one second heat dissipation opening is formed between the second ribs, and on a projection plane parallel to the first plane, at least a portion of the second ribs are staggered with at least a portion of the first ribs. The electronic component is disposed within the device housing, and the first ribs and the second ribs provide visual obstruction for the electronic component.

In one or more embodiments, at least a portion of the first ribs may correspondingly cover the second heat dissipation openings.

In one or more embodiments, at least a portion of the first heat dissipation openings may be correspondingly located above the second ribs.

In one or more embodiments,, a width of the first rib may be greater than a width of the corresponding second heat dissipation opening.

In one or more embodiments, a width of the second rib may be greater than a width of the corresponding first heat dissipation opening.

In one or more embodiments,, in a vertical direction, there may be a gap between a bottom surface of the first rib and a top surface of the corresponding second rib.

In one or more embodiments, the gap may be less than or equal to a thickness of the first rib.

In one or more embodiments, the device housing may comprise a first housing element and a second housing element.

In one or more embodiments, the second housing element may be detachably connected to the first housing element.

In one or more embodiments, the first housing element may comprise a first cover plate.

In one or more embodiments, the first ribs may be formed on the first cover plate.

In one or more embodiments, the second housing element may comprise a second cover plate, and the second ribs are formed on the second cover plate.

In one or more embodiments,, the device housing may further comprise a plurality of first supports, the first support may be disposed on a lower surface of the corresponding first ribs, at least one first support may span two adjacent second ribs and may be supported by the second ribs.

In one or more embodiments,, the first housing element may comprise a first frame, a second frame, a base and the first cover plate.

In one or more embodiments, one end of the first frame may be connected to the base.

In one or more embodiments, one end of the second frame may be connected to the base.

In one or more embodiments, the first frame may be parallel to the second frame.

In one or more embodiments, the other end of the first frame may be connected to the first cover plate.

In one or more embodiments, the other end of the second frame may be connected to the first cover plate.

In one or more embodiments, the first cover plate may correspond to the base.

In one or more embodiments, the second housing element may be connected to one side of the first housing element.

In one or more embodiments, the second cover plate may be located below the first cover plate and may correspond to at least a portion of the first cover plate.

In one or more embodiments, an air inlet may be formed between the second housing element and the base.

In one or more embodiments, the device housing may further comprise a plurality of second supports.

In one or more embodiments, the first housing element may further comprise a support plate.

In one or more embodiments, the support plate may be parallel to the first cover plate.

In one or more embodiments, one end of the support plate may be connected to the first frame.

In one or more embodiments, another end of the support plate may be connected to the second frame.

In one or more embodiments, the second support may be disposed on a lower surface of the corresponding first ribs and is supported by the support plate.

In one or more embodiments, the support plate may be located between the electronic component and the first cover plate.

In one embodiment, the first housing element may further comprise a plurality of hooks.

In one or more embodiments, the second housing element may comprise a plurality of engaging portions.

In one or more embodiments, the hooks may correspondingly engage the engaging portions.

In one or more embodiments, the device housing may further comprise a third housing element.

In one or more embodiments, the third housing element may be detachably connected to another side of the first housing element.

In one or more embodiments, the third housing element may comprise a third cover plate.

In one or more embodiments, the third cover plate may comprise a plurality of third ribs.

In one or more embodiments, the third ribs may be arranged on the second plane.

In one or more embodiments, at least one third heat dissipation opening may be formed between the third ribs and on the projection plane parallel to the first plane.

In one or more embodiments, at least a portion of the third ribs may be staggered with at least a portion of the first ribs.

In one or more embodiments, the third ribs may be parallel to the second ribs.

In one or more embodiments, at least one first support may span two adjacent third ribs and may be supported by the third ribs.

In embodiments of the present disclosure, at least a portion of the second ribs are staggered with at least a portion of the first ribs. From any viewing angle, the first ribs and the second ribs can provide visual obstruction for the electronic component. Additionally, the staggered design with different heights can maintain good ventilation effects. Therefore, compared to prior art, the electronic device of the embodiments of the present disclosure can achieve both heat dissipation efficiency and visual aesthetics.

These and other aspects of the present disclosure will become apparent from the following description of the embodiment taken in conjunction with the following drawings and their captions, although variations and modifications therein may be affected without departing from the spirit and scope of the novel concepts of the present disclosure.

### BRIEF DESCRIPTION OF THE DRAWINGS

The present invention can be more fully understood by reading the subsequent detailed description and examples with references made to the accompanying drawings, wherein:
FIG. 1A is a perspective view of an electronic device according to a first embodiment of the present disclosure.
FIG. 1B is an exploded view of the electronic device according to the first embodiment of the present disclosure.
FIG. 2 is a partial cross-sectional view of the electronic device according to the first embodiment of the present disclosure.
FIG. 3 is a detailed structure of a first support according to the first embodiment of the present disclosure.
FIG. 4 is a detailed structure of a first housing element according to the first embodiment of the present disclosure.
FIG. 5 is an air inlet of according to the first embodiment of the present disclosure.
FIG. 6 is a detailed structure of a second housing element according to the first embodiment of the present disclosure.
FIG. 7 is an exploded view of an electronic device according to a second embodiment of the present disclosure.

### DETAILED DESCRIPTION OF THE INVENTION

The present disclosure is more particularly described in the following examples that are intended as illustrative only since numerous modifications and variations therein will be apparent to those skilled in the art. Like numbers in the drawings indicate like components throughout the views. As used in the description herein and throughout the claims that follow, unless the context clearly dictates otherwise, the meaning of "a," "an" and "the" includes plural reference, and the meaning of "in" includes "in" and "on." Titles or subtitles can be used herein for the convenience of a reader, which shall have no influence on the scope of the present disclosure.

The terms used herein generally have their ordinary meanings in the art. In the case of conflict, the present document, including any definitions given herein, will prevail. The same thing can be expressed in more than one way. Alternative language and synonyms can be used for any term(s) discussed herein, and no special significance is to be placed upon whether a term is elaborated or discussed herein. A recital of one or more synonyms does not exclude the use of other synonyms. The use of examples anywhere in this specification including examples of any terms is illustrative only, and in no way limits the scope and meaning of the present disclosure or of any exemplified term. Likewise, the present disclosure is not limited to various embodiments given herein. Numbering terms such as "first," "second" or "third" can be used to describe various components, signals or the like, which are for distinguishing one component/signal from another one only, and are not intended to, nor should be construed to impose any substantive limitations on the components, signals or the like.

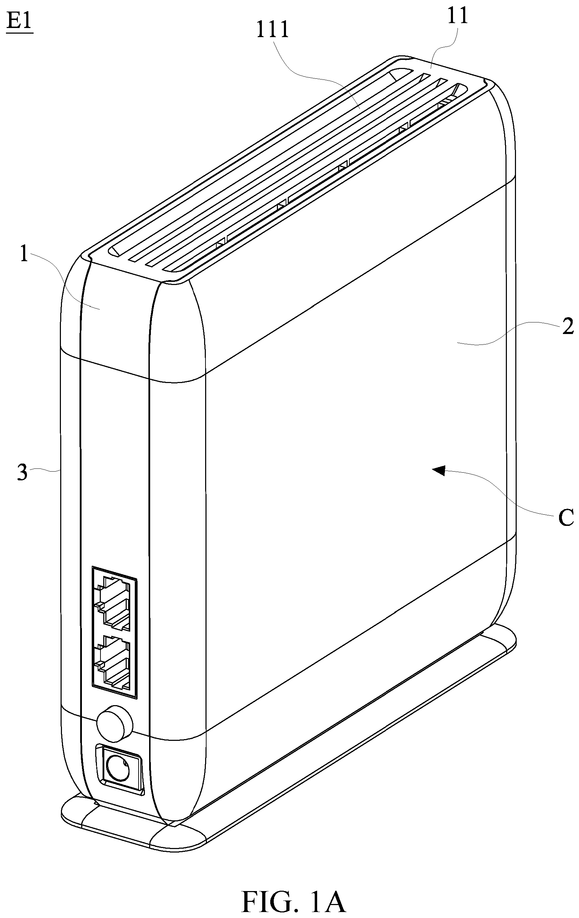

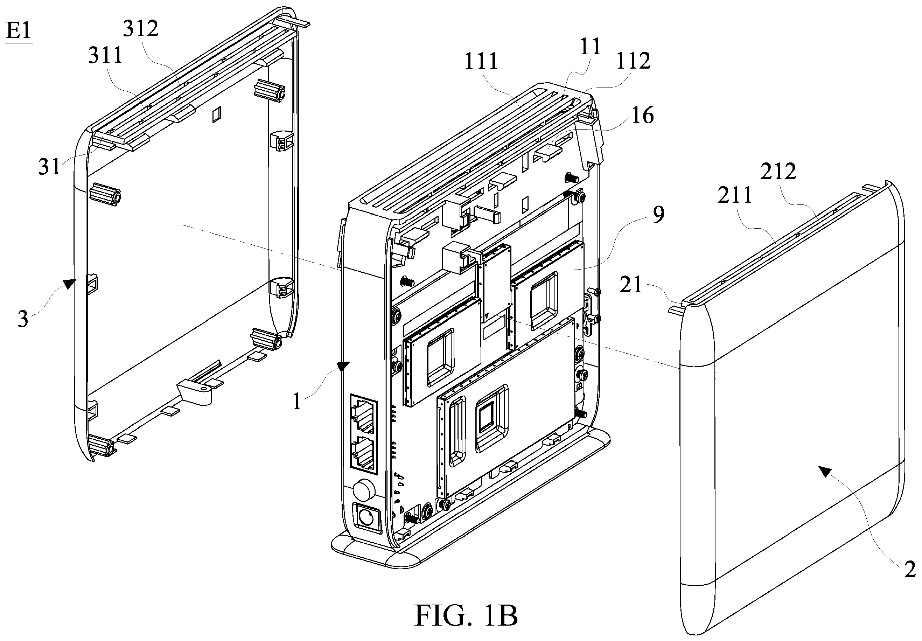

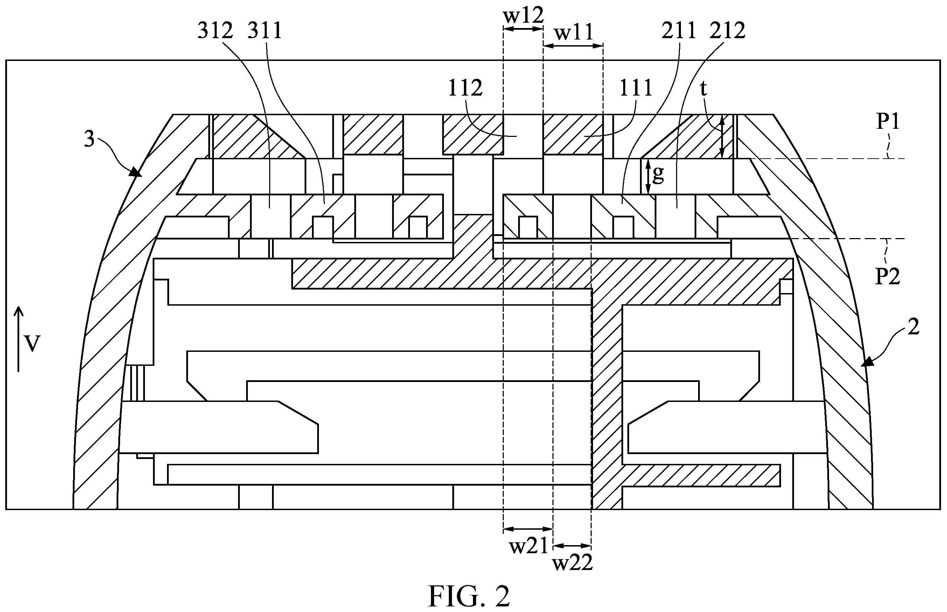

FIG. 1A is a perspective view of an electronic device according to a first embodiment of the present disclosure. FIG. 1B is an exploded view of an electronic device according to the first embodiment of the present disclosure. FIG. 2 is a partial cross-sectional view of an electronic device according to a first embodiment of the present disclosure. Referring to FIGS. 1A, 1B, and 2, an electronic device E1 according to the first embodiment of the present disclosure includes a device housing C and an electronic component 9. The device housing C includes a plurality of first ribs 111 and a plurality of second ribs 211. The first ribs 111 are arranged on a first plane P1. The second ribs 211 are arranged on a second plane P2, the second plane P2 being parallel to the first plane P1, wherein at least one first heat dissipation opening 112 is formed between the first ribs 111, at least one second heat dissipation opening 212 is formed between the second ribs 211, and on a projection plane parallel to the first plane P1, at least a portion of the second ribs 211 are staggered with at least a portion of the first ribs 111. The electronic component 9 is disposed within the device housing C, and the first ribs 111 and the second ribs 211 provide visual obstruction for the electronic component 9.

Referring to FIG. 2, in one embodiment, at least a portion of the first ribs 111 correspondingly cover the second heat dissipation openings 212, and at least a portion of the first heat dissipation openings 112 are correspondingly located above the second ribs 211.

Referring to FIG. 2, in one embodiment, the width w11 of the first ribs 111 is greater than the width w22 of the corresponding second heat dissipation openings 212, and the width w21 of the second ribs 211 is greater than the width w12 of the corresponding first heat dissipation openings 112.

Referring to FIG. 2, in one embodiment, in a vertical direction V, there is a gap g between the bottom surface of the first ribs 111 and the top surface of the corresponding second ribs 211, the gap g being less than or equal to the thickness t of the first ribs 111.

Referring to FIG. 2, in one embodiment, the cross-section of the second ribs 211 can be U-shaped, but the disclosure is not limited thereto. In other embodiments, the cross-section of the second ribs 211 can be other shapes.

Referring to FIGS. 1A and 1B, in one embodiment, the device housing C includes a first housing element 1 and a second housing element 2, the second housing element 2 being detachably connected to the first housing element 1. The first housing element 1 comprises a first cover plate 11, and the first ribs 111 are formed on the first cover plate 11. The second housing element 2 comprises a second cover plate 21, and the second ribs 211 are formed on the second cover plate 21.

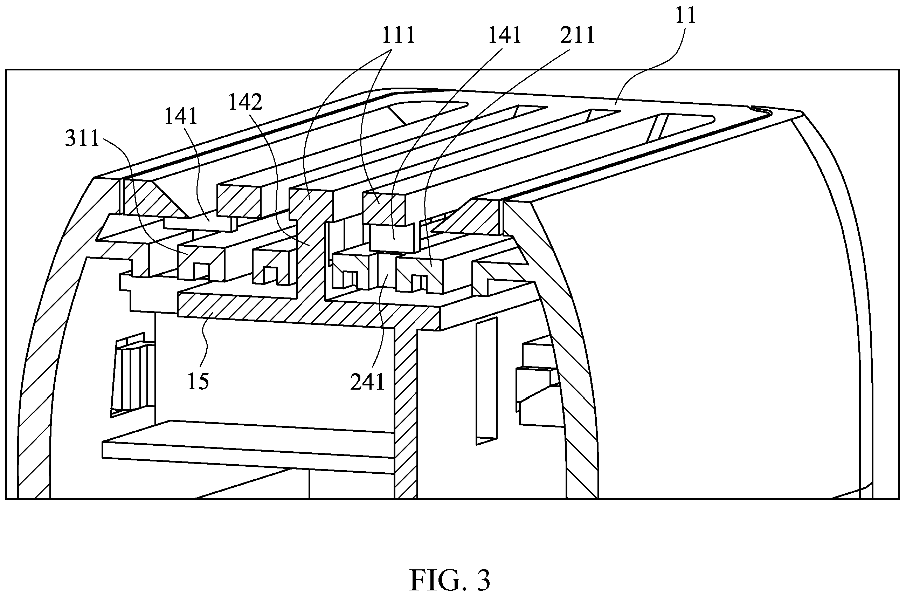

FIG. 3 shows a detailed structure of a first support according to a first embodiment of the present disclosure. Referring to FIG. 3, in one embodiment, the device housing further comprises a plurality of first supports 141, the first support 141 being disposed on the lower surface of the corresponding first ribs 111, with at least one first support 141 spanning two adjacent second ribs 211 and being supported by the second ribs 211.

Referring to FIG. 3, in one embodiment, the device housing further comprises a plurality of reinforcing pieces 241, the reinforcing pieces 241 being disposed between two adjacent second ribs 211 to enhance the structural strength of the second cover plate 21.

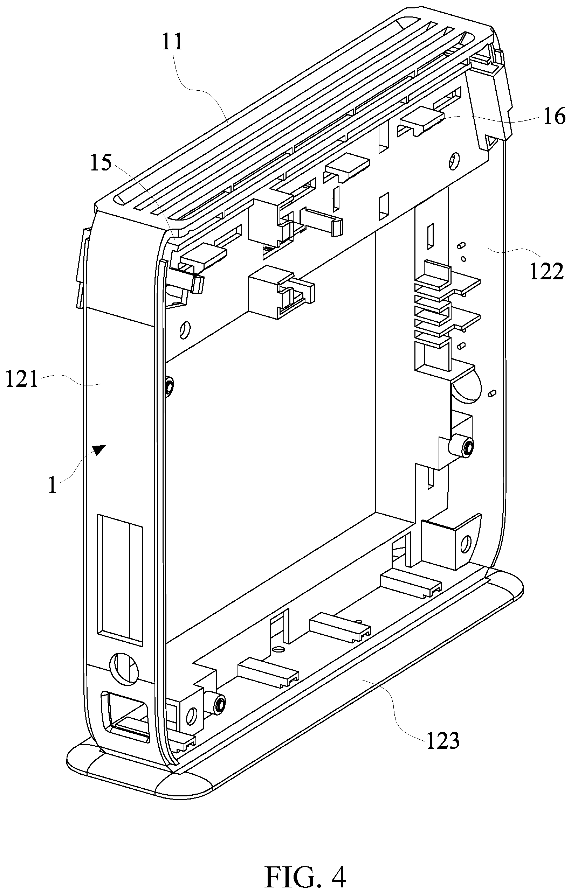

FIG. 4 is a detailed structure of a first housing element according to the first embodiment of the present disclosure. Referring to FIG. 4, in one embodiment, the first housing element 1 includes a first frame 121, a second frame 122, a base 123, and the first cover plate 11. One end of the first frame 121 is connected to the base 123, one end of the second frame 122 is connected to the base 123, the first frame 121 is parallel to the second frame 122, the other end of the first frame 121 is connected to the first cover plate 11, the other end of the second frame 122 is connected to the first cover plate 11, and the first cover plate 11 corresponds to the base 123.

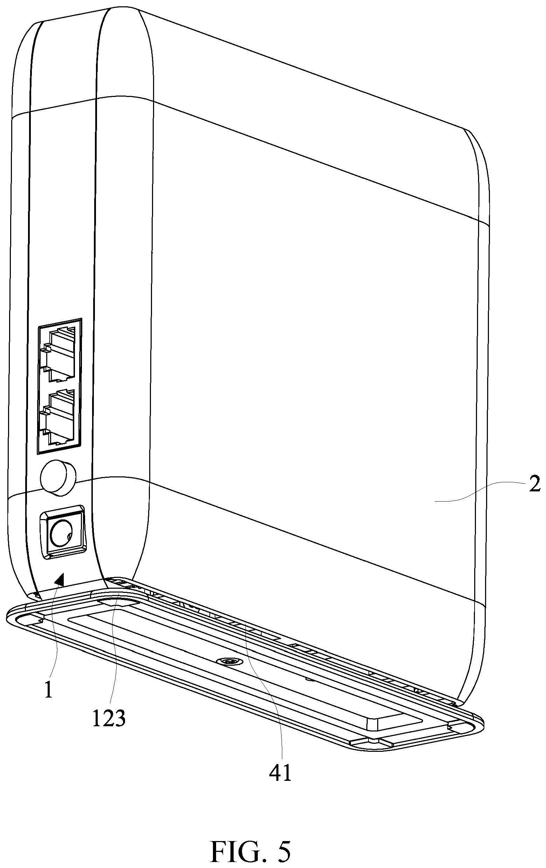

FIG. 5 shows an air inlet according to the first embodiment of the present disclosure. Referring to FIGS. 1A, 1B, and 5, in one embodiment, the second housing element 2 is connected to one side of the first housing element 1, the second cover plate 21 is located below the first cover plate 11 and corresponds to at least a portion of the first cover plate 11, and an air inlet 41 is formed between the second housing element 2 and the base 123.

Referring to FIGS. 3 and 4, in one embodiment, the device housing C further comprises a plurality of second supports 142, wherein the first housing element 1 further comprises a support plate 15. The support plate 15 is parallel to the first cover plate 11, one end of the support plate 15 is connected to the first frame 121, the other end of the support plate 15 is connected to the second frame 122, and the second support 142 is disposed on the lower surface of the corresponding first ribs 111 and are supported by the support plate 15.

Referring to FIG. 3, in one embodiment, the support plate 15 is located between the electronic component (not shown) and the first cover plate 11.

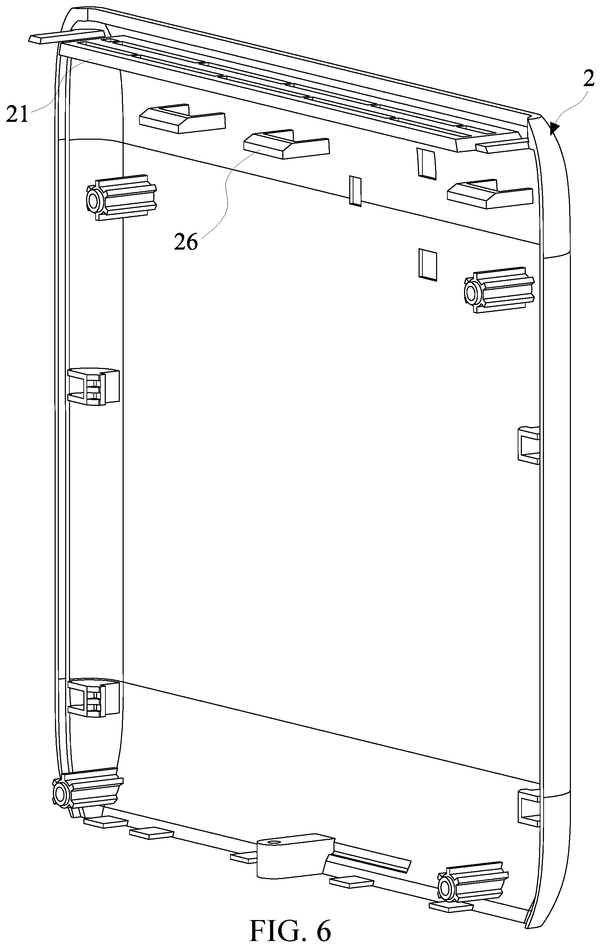

FIG. 6 is a detailed structure of a second housing element according to the first embodiment of the present disclosure. Referring to FIGS. 1B, 4, and 6, in one embodiment, the first housing element 1 further comprises a plurality of hooks 16, and the second housing element 2 comprises a plurality of engaging portions 26, wherein the hooks 16 correspondingly engage the engaging portions 26.

Referring to FIGS. 1A, 1B, and 2, in one embodiment, the device housing further comprises a third housing element 3, the third housing element 3 being detachably connected to the other side of the first housing element 1. The third housing element 3 comprises a third cover plate 31, the third cover plate 31 comprising a plurality of third ribs 311. The third ribs 311 are arranged on the second plane P2, at least one third heat dissipation opening 312 is formed between the third ribs 311, and on the projection plane parallel to the first plane P1, at least a portion of the third ribs 311 are staggered with at least a portion of the first ribs 111.

Referring to FIGS. 1A, 1B, 2, and 3, in one embodiment, the third ribs 311 are parallel to the second ribs 211, and at least one first support 141 spans two adjacent third ribs 311 and is supported by the third ribs 311.

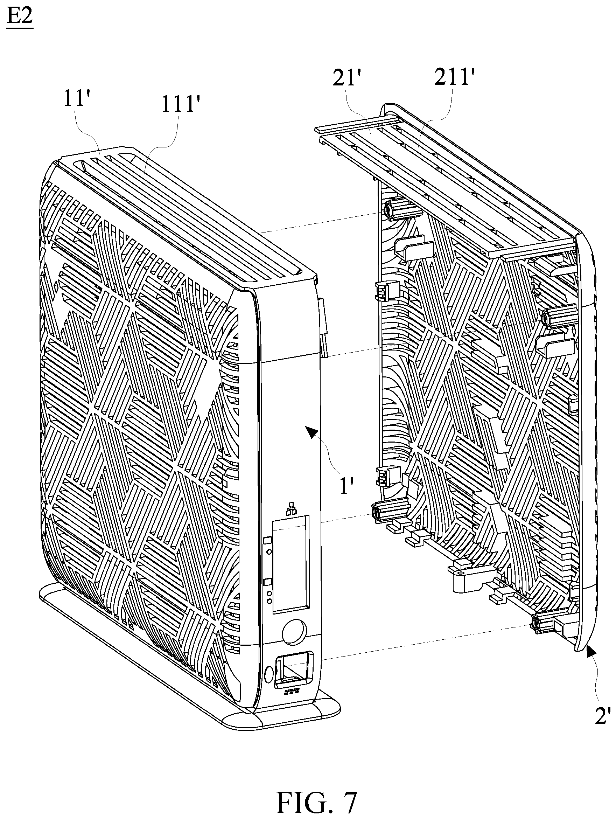

In the above embodiments, the device housing further comprises a third housing element, the third cover plate comprises a plurality of third ribs, and at least one third heat dissipation opening is formed between the third ribs. However, the disclosure is not limited thereto. In another embodiment, the third housing element might not have a cover plate and ribs; or the third housing element may be omitted. FIG. 7 is an exploded view of an electronic device according to a second embodiment of the present disclosure. Referring to FIG. 7, in this embodiment, an electronic device E2 according to the second embodiment of the present disclosure includes a first housing element 1' and a second housing element 2', the second housing element 2' being detachably connected to the first housing element 1'. The first housing element 1' comprises a first cover plate 11', the first ribs 111' are formed on the first cover plate 11', the second housing element 2' comprises a second cover plate 21', and the second ribs 211' are formed on the second cover plate 21'. At least a portion of the second ribs 211' are staggered with at least a portion of the first ribs 111' to provide a visual obstruction effect.

In embodiments of the present disclosure, at least a portion of the second ribs are staggered with at least a portion of the first ribs. From any viewing angle, the first ribs and the second ribs can provide visual obstruction for the electronic component. Additionally, the staggered design with different heights can maintain good ventilation effects. Therefore, compared to conventional art, the electronic device of the embodiments of the present disclosure can achieve both heat dissipation efficiency and visual aesthetics.

The foregoing description of the embodiments of the disclosure has been presented only for the purposes of illustration and description and is not intended to be exhaustive or to limit the disclosure to the precise forms disclosed. Many modifications and variations are possible in light of the above teaching. The embodiments were chosen and described in order to explain the principles of the disclosure and their practical applications. Alternative embodiments will become apparent to the skilled person to which the disclosure pertains without departing from its scope.

## Claims

1. An electronic device, comprising:
a device housing (C), including:
a plurality of first ribs (111), arranged on a first plane (P1); and
a plurality of second ribs (211), arranged on a second plane (P1), the second plane (P2) being parallel to the first plane (P1),
wherein at least a first heat dissipation opening (112) is formed between the first ribs (111), at least a second heat dissipation opening (212) is formed between the second ribs (211), and on a projection plane parallel to the first plane (P1), at least a portion of the second ribs (211) are staggered with at least a portion of the first ribs (111); and an electronic component (9) disposed within the device housing, the first ribs (111) and the second ribs (211) providing visual obstruction for the electronic component (9).

2. The electronic device according to claim 1, wherein at least a portion of the first ribs (111) correspondingly cover the second heat dissipation openings (212), and at least a portion of the first heat dissipation openings (112) are correspondingly located above the second ribs (211).

3. The electronic device according to claim 1 or 2, wherein a width of the first rib (111) is greater than a width of the corresponding second heat dissipation opening (212), and a width of the second rib (211) is greater than a width of the corresponding first heat dissipation opening (112).

4. The electronic device according to any one of the preceding claims, wherein in a vertical direction, there is a gap (g) between a bottom surface of the first rib (111) and a top surface of the corresponding second rib (211), the gap (g) being less than or equal to a thickness of the first rib (111).

5. The electronic device according to any one of the preceding claims, wherein the device housing comprises a first housing element (1) and a second housing element (2), the second housing element (2) being detachably connected to the first housing element (1), the first housing element (1) comprises a first cover plate (11), the first ribs (111) are formed on the first cover plate (11), the second housing element (2) comprises a second cover plate (21), and the second ribs (211) are formed on the second cover plate (21).

6. The electronic device according to claim 5, wherein the device housing further comprises a plurality of first supports (141), the first support (141) being disposed on a lower surface of the corresponding first ribs (111), at least one first support (141) spans two adjacent second ribs (211) and is supported by the second ribs (211).

7. The electronic device according to claim 5 or 6, wherein the first housing element (1) comprises a first frame (121), a second frame (122), a base (123) and the first cover plate (11), one end of the first frame (121) is connected to the base (23), one end of the second frame (122) is connected to the base (123), the first frame (121) being parallel to the second frame (122), the other end of the first frame(121) is connected to the first cover plate (11), the other end of the second frame (122) is connected to the first cover plate (11), and the first cover plate (11) corresponds to the base (123).

8. The electronic device according to claim 7, wherein the second housing element (2) is connected to one side of the first housing element (1), the second cover plate (21) is located below the first cover plate (11) and corresponds to at least a portion of the first cover plate (11), and an air inlet (41) is formed between the second housing element (21) and the base (123).

9. The electronic device according to claim 7 or 8, wherein the device housing further comprises a plurality of second supports (142), wherein the first housing element (1) further comprises a support plate (15), the support plate (15) being parallel to the first cover plate (11), one end of the support plate (15) is connected to the first frame (121), another end of the support plate (15) is connected to the second frame (122), the second support (122) is disposed on a lower surface of the corresponding first ribs (111) and is supported by the support plate (15).

10. The electronic device according to claim 9, wherein the support plate (15) is located between the electronic component (9) and the first cover plate (11).

11. The electronic device according to claim 7, 8, 9, or 10 wherein the first housing element (1) further comprises a plurality of hooks (16), the second housing element (2) comprises a plurality of engaging portions (26), and the hooks (16) correspondingly engage the engaging portions (26).

12. The electronic device according to any one of the preceding claims 8-11, wherein the device housing further comprises a third housing element (3), the third housing element (3) being detachably connected to another side of the first housing element (1), the third housing element (3) comprises a third cover plate (31), the third cover plate (31) comprising a plurality of third ribs (311), the third ribs (311) being arranged on the second plane (P2), at least one third heat dissipation opening (312) is formed between the third ribs (311), and on the projection plane parallel to the first plane (P1), at least a portion of the third ribs (311) are staggered with at least a portion of the first ribs (111).

13. The electronic device according to claim 12, wherein the third ribs (311) are parallel to the second ribs (211), and at least one first support (141) spans two adjacent third ribs (311) and is supported by the third ribs (311).
